# EUROPEAN PATENT SPECIFICATION

(11) **EP 3 419 059 B1**
(45) Date of publication and mention of the grant of the patent: **25.12.2019**
(21) Application number: 18189436.1
(22) Date of filing: 07.07.2016
(51) Int. Cl.: H01L 31/18

(54) **METHOD OF MANUFACTURING A SOLAR CELL**
VERFAHREN ZUR HERSTELLUNG EINER SOLARZELLE
PROCÉDÉ DE FABRICATION D'UNE CELLULE SOLAIRE

(30) Priority: 07.07.2015 KR 20150096764
(43) Date of publication of application: 26.12.2018
(62) Divisional of application: 16178363.4
(73) Proprietor: LG Electronics Inc., Seoul 07336 (KR)
(72) Inventor: LEE, Daeyong, 08592 Seoul (KR); AHN, Junyong, 08592 Seoul (KR); YI, Mann, 08592 Seoul (KR); KIM, Jeongkyu, 08592 Seoul (KR)
(74) Representative: Katérle, Axel

(56) References cited:
- EP-A2- 2 528 105
- US-A- 4 758 525

## Description

### BACKGROUND

### 1. Technical Field

Embodiments of the present inventive concept relate to a method of manufacturing a solar cell, and more particularly, to a method of manufacturing a solar cell, which has excellent properties attributable to improvement in a manufacturing method.

### 2. Description of the Related Art

Recently, due to depletion of existing energy resources, such as oil and coal, interest in alternative sources of energy to replace the existing energy resources is increasing. Most of all, solar cells are popular next generation cells to convert sunlight into electrical energy.

Solar cells may be manufactured by forming various layers and electrodes based on some design. The efficiency of solar cells may be determined by the design of the various layers and electrodes. In order for solar cells to be commercialized, the problem of low efficiency needs to be overcome, and thus, there is a demand to design the various layers and electrodes so as to maximize the efficiency of solar cells and to be manufactured via a simplified method.
EP 2 528 105 A2 discloses a method for manufacturing a back electrode-type solar cell, comprising: preparing an n-type crystalline silicon substrate; forming a thermal diffusion control film on a front surface, a back surface and a side surface of the substrate; forming a p-type impurity region by implanting p-type impurity ions onto the back surface of the substrate; patterning the thermal diffusion control film so that the back surface of the substrate is selectively exposed; and forming a high-concentration back field layer (n+) at an exposed region of the back surface of the substrate and a low-concentration front field layer (n-) at the front surface of the substrate by performing a thermal diffusion process, and forming a p+ emitter region by activating the p-type impurity region.

### SUMMARY

Therefore, the embodiments of the present inventive concept have been made in view of the above problems, and it is an object of the embodiments of the present inventive concept to provide a solar cell having excellent efficiency and high productivity and a method of manufacturing the same.

The method according to the present invention is defined in claim 1. Preferred features are defined in the dependent claims. The following aspects describe embodiments useful for understanding the invention. In accordance with one aspect, the above and other objects can be accomplished by the provision of a method of manufacturing a solar cell including forming a barrier film over at least one surface of a semiconductor substrate or a semiconductor layer, forming a first conductive area on the at least one surface of the semiconductor substrate or the semiconductor layer via ion implantation of a first conductive dopant through the barrier film, and removing the barrier film.

Moreover, there is disclosed a solar cell including a semiconductor substrate, a conductive area formed on or over the semiconductor substrate, the conductive area including a first conductive area of a first conductive type and a second conductive area of a second conductive type opposite to the first conductive type, and an electrode including a first electrode connected to the first conductive area and a second electrode connected to the second conductive area, wherein the first conductive area includes boron as a first conductive dopant, wherein the first conductive area has a junction depth smaller than a junction depth of the second conductive area, and wherein a surface doping concentration in the first conductive area and a surface doping concentration in the second conductive area have a difference within 30%.

### BRIEF DESCRIPTION OF THE DRAWINGS

The above and other objects, features and other advantages of the present inventive concept will be more clearly understood from the following detailed description taken in conjunction with the accompanying drawings, in which:
FIG. 1 is a sectional view illustrating one example of a solar cell manufactured by a method of manufacturing a solar cell in accordance with an embodiment of the present inventive concept;
FIG. 2 is a partial rear plan view of the solar cell illustrated in FIG. 1;
FIGS. 3A to 3H are sectional views illustrating a method of manufacturing a solar cell in accordance with an embodiment of the present inventive concept; and
FIG. 4 is a graph illustrating the concentration of a first conductive dopant depending on a distance from the surface of a semiconductor substrate in solar cells in accordance with an experimental example and a comparative example.

### DETAILED DESCRIPTION OF THE EMBODIMENTS

Reference will now be made in detail to the embodiments of the present inventive concept, examples of which are illustrated in the accompanying drawings. However, it will be understood that the present inventive concept should not be limited to the embodiments and may be modified in various ways.

In the drawings, to clearly and briefly explain the present inventive concept, illustration of elements having no connection with the description is omitted, and the same or similar elements are designated by the same reference numerals throughout the specification. In addition, in the drawings, for a more clear explanation, the dimensions of elements, such as thickness, width, and the like, are exaggerated or reduced, and thus the thickness, width, and the like of the embodiments of the present inventive concept are not limited to the illustration of the drawings.

In the entire specification, when an element is referred to as "including" another element, the element should not be understood as excluding other elements so long as there is no special conflicting description, and the element may include at least one other element. In addition, it will be understood that, when an element such as a layer, film, region or substrate is referred to as being "on" another element, it can be directly on the other element or intervening elements may also be present. On the other hand, when an element such as a layer, film, region or substrate is referred to as being "directly on" another element, this means that there are no intervening elements therebetween.

Hereinafter, a solar cell and a method of manufacturing the same in accordance with the embodiments of the present inventive concept will be described in detail with reference to the accompanying drawings. The solar cell in accordance with the embodiment of the present inventive concept will first be described, and thereafter the method of manufacturing the solar cell in accordance with the embodiment of the present inventive concept will be described.

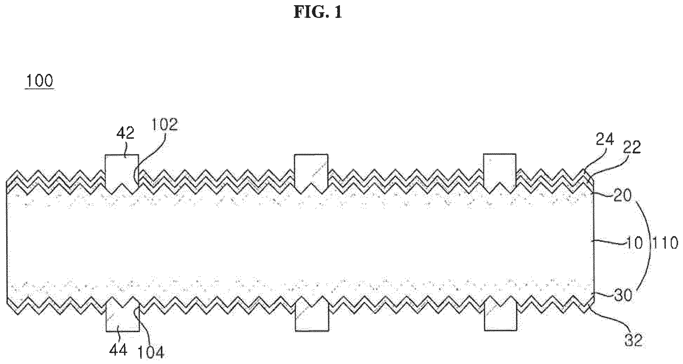

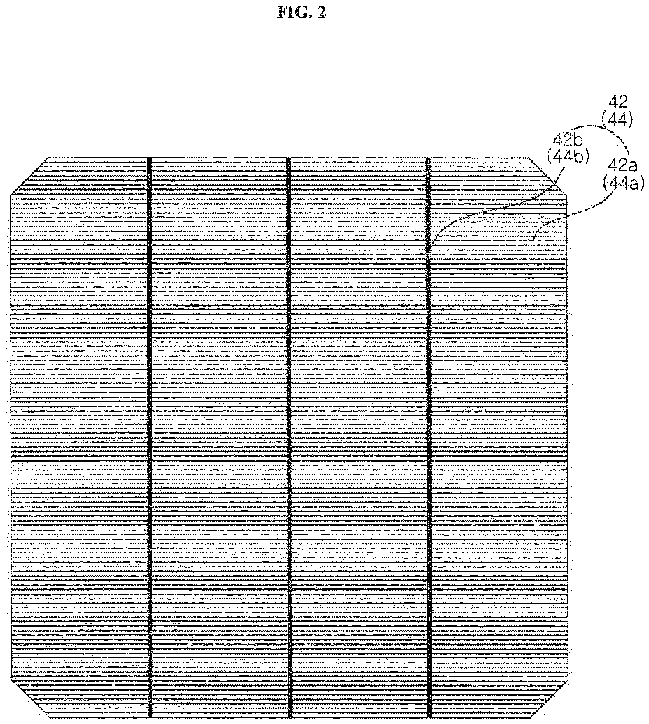

FIG. 1 is a sectional view illustrating one example of a solar cell, manufactured by a method of manufacturing a solar cell, in accordance with an embodiment of the present inventive concept, and FIG. 2 is a partial rear plan view of the solar cell illustrated in FIG. 1. In FIG. 2, illustration is focused on a semiconductor substrate 110 and first and second electrodes 42 and 44.

Referring to FIG. 1, the solar cell in accordance with the present embodiment, designated by reference numeral 100, includes a semiconductor substrate 110 having a base area 10, conductive areas 20 and 30, and electrodes 42 and 44 connected to the base area 10 and/or the conductive areas 20 and 30. The conductive areas 20 and 30 may include a first conductive area 20 of a first conductive type, and a second conductive area 30 of a second conductive type. In addition, the first electrode 42 is electrically connected to the first conductive area 20, and the second electrode 44 is electrically connected to the base area 10 or the second conductive area 30. Here, the terms "first", "second", etc. are simply used in order to distinguish elements from each other, and the present inventive concept is not limited thereto. In addition, the solar cell 100 may further include, for example, passivation films 22 and 32 and an anti-reflection film 24. This will be described below in more detail.

The semiconductor substrate 110 may include the conductive areas 20 and 30, and the base area 10, which is a portion in which the conductive areas 20 and 30 are not formed.

In the present embodiment, the semiconductor substrate 110 may be formed of crystalline semiconductors. In one example, the semiconductor substrate 110 may be formed of monocrystalline or polycrystalline semiconductors (e.g. monocrystalline or polycrystalline silicon). In particular, the semiconductor substrate 110 may be formed of monocrystalline semiconductors (e.g. a monocrystalline semiconductor wafer, and more specifically, a semiconductor silicon wafer). As such, the solar cell 100, which includes the semiconductor substrate 110 formed as described above, is formed of crystalline semiconductors (e.g. monocrystalline semiconductors, such as monocrystalline silicon). The solar cell 100 formed of crystalline semiconductors may achieve excellent electrical properties because the solar cell 100 is based on the semiconductor substrate 110 formed of monocrystalline semiconductors, which have few defects attributable to their high crystallinity.

In the present embodiment, each of the base area 10 and the conductive areas 20 and 30, which constitute a portion of the semiconductor substrate 110, may be defined by a dopant included therein. For example, an area of the semiconductor substrate 110, which includes a first conductive dopant, and thus, is of a first conductive type, may be defined as the first conductive area 20, an area of the semiconductor substrate 110, which includes a second conductive dopant at a low doping concentration, and thus, is of a second conductive type, may be defined as the base area 10, and an area of the semiconductor substrate 110, which includes the second conductive dopant at a higher doping concentration than that in the base area 10, and thus, is of the second conductive type, may be defined as the second conductive area 30. That is, the base area 10 and the conductive areas 20 and 30 are areas, which have a crystalline structure of the semiconductor substrate 110, are of different conductive types, and have different doping concentrations.

The present embodiment illustrates that the conductive areas 20 and 30 are doped area, which are formed by doping the inside of the semiconductor substrate 110 with different dopants, and constitute a portion of the semiconductor substrate 110. However, the embodiment of the present inventive concept is not limited thereto. Thus, at least one of the first conductive area 20 and the second conductive area 30 may be formed of, for example, an amorphous, microcrystalline, or polycrystalline semiconductor layer, which is configured as a separate layer over the semiconductor substrate 110. Various other alterations are possible.

The first conductive type is a p-type, and the second conductive type is an n-type opposite to the first conductive type. Boron (B), which is a group III element, is used as the p-type dopant, and a group V element, such as phosphorus (P), arsenic (As), bismuth (Bi), or antimony (Sb), may be used as the n-type dopant. The second conductive dopant in the base area 10 and the second conductive dopant in the second conductive area 30 may be the same material, or may be different materials.

In one example, the first conductive area 20 is of a p-type, and the base area 10 and the second conductive area 30 may be of an n-type. When light is emitted to a pn junction formed by the first conductive area 20 and the base area 10, electrons generated via photoelectric conversion move to the back surface of the semiconductor substrate 110 to thereby be collected by the second electrode 44, and holes move to the front surface of the semiconductor substrate 110 to thereby be collected by the first electrode 42. Thereby, electricity is generated. When holes, which move more slowly than electrons, move to the front surface of the semiconductor substrate 110, rather than the back surface, the conversion efficiency may be improved.

The front surface and/or the back surface of the semiconductor substrate 110 may be subjected to texturing so as to form protrusions having inclined outer surfaces (i.e. slopes on the front surface or the back surface of the semiconductor substrate 110). At this time, the inclined surface of the protrusion may be configured by a specific surface of the semiconductor substrate 110 (e.g. (111) face of silicon), and the protrusion may take the form of a pyramid, the outer surface of which is (111) face. When the protrusions are formed on, for example, the front surface of the semiconductor substrate 110 via texturing, the reflectance of light introduced through, for example, the front surface of the semiconductor substrate 110 may be reduced. Accordingly, the quantity of light, which reaches a pn junction formed on the interface of the base area 10 and the first conductive area 20, may be increased, which may minimize the loss of light. However, the embodiment of the present inventive concept is not limited thereto, and no protrusion may be formed on the front surface and the back surface of the semiconductor substrate 110 via texturing.

The first conductive area 20 may be formed on the front surface of the semiconductor substrate 110, and the second conductive area 30 may be formed on the back surface of the semiconductor substrate 110. That is, the first conductive area 20 and the second conductive area 30 may be located with the base area 10 interposed therebetween. However, the embodiment of the present inventive concept is not limited thereto. The arrangement of the base area 10, the first conductive area 20, and the second conductive area 30 may be altered in various ways.

The first conductive area 20 may configure an emitter area for forming a pn junction with the base area 10. The second conductive area 30 may configure a back surface field area for forming a back surface field. The back surface field area serves to prevent the loss of carriers attributable to recombination on the surface of the semiconductor substrate 110 (more accurately, the back surface of the semiconductor substrate 110).

The present embodiment illustrates that each of the first conductive area 20 and the second conductive area 30 has a homogeneous structure having a consistent doping concentration in the entire region thereof. However, the embodiment of the present inventive concept is not limited thereto. Thus, in another embodiment, at least one of the first conductive area 20 and the second conductive area 30 may have a selective structure. In the selective structure, a portion of the conductive area 20 or 30 proximate to the first or second electrode 42 and 44 may have a high doping concentration, low resistance, and deep junction depth, and the remaining portion may have a low doping concentration, high resistance, and shallow junction depth. In a further embodiment, the second conductive area 30 may have a local structure. In the local structure, the second conductive area 30 may be locally formed so as to correspond to a portion in which the second electrode 44 is formed.

Insulation films, such as the passivation films 22 and 32 and the anti-reflection film 24, may be formed over the surface of the semiconductor substrate 110. The insulation films may be configured as undoped insulation films having no dopant.

More specifically, the passivation film 22 may be formed over (e.g. in contact with) the front surface of the semiconductor substrate 110, more accurately, over the first conductive area 20 formed on the semiconductor substrate 110, and the anti-reflection film 24 may be formed over (e.g. in contact with) the passivation film 22. In addition, the passivation film 32 may be formed over the back surface of the semiconductor substrate 110, more accurately, over the second conductive area 30 formed on the semiconductor substrate 110.

The passivation film 22 and the anti-reflection film 24 may be formed substantially throughout the entire front surface of the semiconductor substrate 110, excluding a portion corresponding to the first electrode 42 (more accurately, a portion in which a first opening 102 is formed). Similarly, the passivation film 32 may be formed substantially throughout the entire back surface of the semiconductor substrate 110, excluding a portion corresponding to the second electrode 44 (more accurately, a portion in which a second opening 104 is formed).

The passivation films 22 and 32 are formed in contact with the conductive areas 20 and 30 so as to passivate defects present in a surface or a bulk of the conductive areas 20 and 30. This may remove recombination sites of minority carriers, thereby increasing the open-circuit voltage Voc of the solar cell 100. The anti-reflection film 24 reduces the reflectance of light introduced into the front surface of the semiconductor substrate 110. Such a reduction in the reflectance of light, introduced through the front surface of the semiconductor substrate 110, may increase the quantity of light reaching the pn-j unction formed on the interface of the base area 10 and the first conductive area 20. In this way, the short-circuit current Isc of the solar cell 100 may be increased. The increased open-circuit voltage and the short-circuit current of the solar cell 100 attributable to the passivation films 22 and 32 and the anti-reflection film 24 may increase the efficiency of the solar cell 100.

In one example, the passivation films 22 and 32 or the anti-reflection film 24 may be a single film or multiple films having the form of a combination of two or more films selected from among the group of a silicon nitride film, a silicon nitride film containing hydrogen, a silicon oxide film, a silicon oxide nitride film, an aluminum oxide film, MgF₂, ZnS, TiO₂ and CeO₂. In one example, the passivation films 22 and 32 may include a silicon oxide film or a silicon nitride film having fixed positive charge when the conductive areas 20 and 30 are of the n-type, and may include an aluminum oxide film having fixed negative charge when the conductive areas 20 and 30 are of the p-type. In one example, the anti-reflection film 24 may be formed of a silicon nitride.

However, the embodiment of the present inventive concept is not limited thereto, and the passivation films 22 and 32 and the anti-reflection film 24 may include various materials. In addition, the structure in which the insulation films are stacked one above another over the front surface and/or the back surface of the semiconductor substrate 110 may be altered in various ways. For example, the insulation films may be stacked in a sequence, which is different from the above-described stacking sequence. Alternatively, at least one of the passivation films 22 and 32 and the anti-reflection film 24 described above may not be provided, or other insulation films excluding the passivation films 22 and 32 and the anti-reflection film 24 described above may be provided. Various other alterations are possible.

The first electrode 42 is electrically connected to the first conductive area 20 through the first opening 102, which is formed in the insulation films disposed on the front surface of the semiconductor substrate 110 (e.g. the passivation film 22 and the anti-reflection film 24). The second electrode 44 is electrically connected to the second conductive area 30 through the second opening 104, which is formed in the insulation film disposed on the back surface of the semiconductor substrate 110 (e.g. the passivation film 32). In one example, the first electrode 42 may come into contact with the first conductive area 20, and the second electrode 44 may come into contact with the second conductive area 30.

The first and second electrodes 42 and 44 may be formed of various materials (e.g. metal materials) so as to have various shapes. The shapes of the first and second electrodes 42 and 44 will be described below with reference to FIG. 2.

Referring to FIG. 2, each of the first and second electrodes 42 and 44 may include a plurality of finger electrodes 42a or 44a, which are spaced apart from one another at a constant pitch. Although FIG. 2 illustrates that the finger electrodes 42a or 44a are parallel to one another and are also parallel to the edge of the semiconductor substrate 110, the present inventive concept is not limited thereto. In addition, the first and second electrodes 42 and 44 may include bus bar electrodes 42b and 44b, which are formed in the direction crossing the finger electrodes 42a and 44a so as to connect the finger electrodes 42a and 44a to one another. Only one bus bar electrode 42b or 44b may be provided, or a plurality of bus bar electrodes 42b or 44b may be arranged at a larger pitch than the pitch of the finger electrodes 42a or 44a as exemplarily illustrated in FIG. 2. At this time, although the width of the bus bar electrodes 42b and 44b may be larger than the width of the finger electrodes 42a and 44a, the present inventive concept is not limited thereto. Accordingly, the width of the bus bar electrodes 42b and 44b may be equal to or less than the width of the finger electrodes 42a and 44a.

When viewing the cross section, both the finger electrode 42a and the bus bar electrode 42b of the first electrode 42 may be formed so as to penetrate the passivation film 22 and the anti-reflection film 24. That is, the opening 102 may be formed so as to correspond to both the finger electrode 42a and the bus bar electrode 42b of the first electrode 42. In addition, both the finger electrode 44a and the bus bar electrode 44b of the second electrode 44 may be formed so as to penetrate the passivation film 32. That is, the opening 104 may be formed so as to correspond to both the finger electrode 44a and the bus bar electrode 44b of the second electrode 44. However, the embodiment of the present inventive concept is not limited thereto. In another example, the finger electrode 42a of the first electrode 42 may be formed so as to penetrate the passivation film 22 and the anti-reflection film 24 and the bus bar electrode 42b may be formed over the passivation film 22 and the anti-reflection film 24. In this instance, the finger electrode 44a of the second electrode 44 may be formed so as to penetrate the passivation film 32, and the bus bar electrode 44b may be formed over the passivation film 32.

In the present embodiment, the first and second electrodes 42 and 44 of the solar cell 100 have a given pattern so that the solar cell 100 has a bi-facial structure to allow light to be introduced into the front surface and the back surface of the semiconductor substrate 110. As such, the quantity of light for use in the solar cell 100 may be increased, which may contribute to improvement in the efficiency of the solar cell 100.

FIG. 2 illustrates that the first electrode 42 and the second electrode 44 have the same shape. However, the embodiment of the present inventive concept is not limited thereto, and for example, the widths and pitches of the finger electrodes 42a and the bus bar electrodes 42b of the first electrode 42 may be different from the widths and pitches of the finger electrodes 44a and the bus bar electrodes 44b of the second electrode 44. In addition, the first electrode 42 and the second electrode 44 may have different shapes, and various other alterations are possible. For example, the second electrode 44 may have no pattern and may be formed throughout the entire back surface of the semiconductor substrate 110.

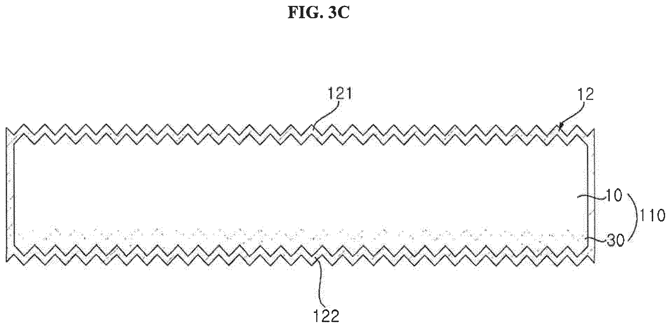

In the present embodiment, the conductive areas 20 and 30 having excellent properties may be formed via improvement in the process of forming the conductive areas 20 and 30. In particular, in the present embodiment, a barrier film 12 (FIG. 3C) is formed when the first conductive area 20 including boron B is formed, which may reduce the junction depth of the first conductive area 20. Nevertheless, because the first conductive area 20 and the second conductive area 30 have similar surface doping concentrations (having a difference within 30%), the first conductive area 20 and the second conductive area 30 may have low contact resistance of the first electrode 44 or the second electrode 44. In one example, the surface doping concentration in the first conductive area 20 may be within a range from 1 x 10¹⁹/cm³ to 1 x 10²¹/cm³, and the surface doping concentration of the second conductive area 30 may be within a range from 1 x 10¹⁹/cm³ to 1 x 10²¹/cm³. However, the embodiment of the present inventive concept is not limited thereto.

More specifically, the junction depth of the first conductive area 20 is smaller than the junction depth of the second conductive area 30. In one example, the ratio of the junction depth of the second conductive area 30 to the junction depth of the first conductive area 20 may be within a range from 1:0.4 to 1:0.8. Alternatively, the junction depth of the first conductive area 20 may be within a range from 0.5*µ*m to 0.8*µ*m, and the junction depth of the second conductive area 30 may be within a range from 0.8*µ*m to 1.3*µ*m. This is because this range ensures that the first conductive area 20 sufficiently serves as an emitter area even while forming a shallow emitter. However, the embodiment of the present inventive concept is not limited thereto.

In addition, the concentration of impurities in the first conductive area 20 and the second conductive area 30 may be maintained at a relatively low level. In particular, the concentration of metal impurities (e.g. Mg, Al, Fe and Cr) in the first conductive area 20 may be similar to the concentration of metal impurities in the second conductive area 30 (so that a difference therebetween is within 20%). The second conductive area 30 is formed using, for example, a hydride including a second conductive dopant (e.g. a hydride, such as PH₃, when phosphorus is used as the second conductive dopant), and therefore, may have a low concentration of impurities despite the implementation of ion implantation without a mass analyzer. The first conductive area 20 is formed via ion implantation using a fluoride including a first conductive dopant (e.g. a fluoride, such as BF₃ or B₂F₄ when boron is used as the first conductive dopant), and thus, has a high possibility of including other impurities. Therefore, the barrier film 12 is provided in order to filter out the impurities. In this way, the first and second conductive areas 20 and 30 may have a low concentration of impurities even without using a mass analyzer.

The above description illustrates that the first conductive area 20 including boron is the emitter area and the second conductive area 30 including phosphorous is the back surface field area. However, the embodiment of the present inventive concept is not limited thereto. Thus, the emitter area may be the second conductive area 30 including phosphorous, and the back surface field area may be the first conductive area 20 including boron. Various other alterations are possible.

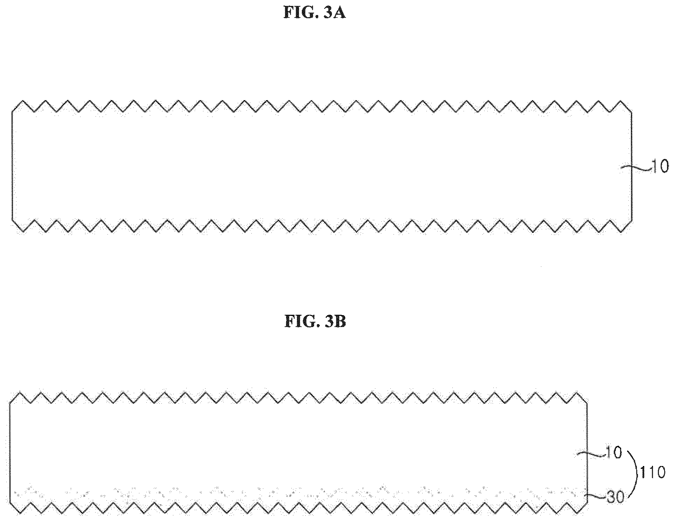

Hereinafter, the method of manufacturing the solar cell 100 in accordance with the embodiment of the present inventive concept will be described in detail with reference to FIGS. 3A to 3H. A detailed description of the above-described parts is omitted, and only parts not described above will be described below in detail.

FIGS. 3A to 3H are sectional views illustrating a method of manufacturing a solar cell in accordance with an embodiment of the present inventive concept.

Referring to FIG. 3A, the semiconductor substrate 110, which includes the base area 10 including a second conductive dopant, is prepared. In one example, in the present embodiment, the semiconductor substrate 110 may be a silicon substrate (e.g. a silicon wafer) including an n-type dopant (in particular, phosphorous (P)). However, the embodiment of the present inventive concept is not limited thereto, and the base area 10 may have an n-type dopant excluding phosphorus, or a p-type dopant.

At this time, at least one surface of the front surface and the back surface of the semiconductor substrate 110 may be subjected to texturing so as to form protrusions. The texturing on the surface of the semiconductor substrate 110 may be wet or dry texturing. Wet texturing may be performed by dipping the semiconductor substrate 110 into a texturing solution, and has the advantage of a short process time. Dry texturing is the process of grinding the surface of the semiconductor substrate 110 using, for example, a diamond grill or laser, and may entail the disadvantages of a long process time and the potential for damage to the semiconductor substrate 110, although it may be advantageous in that protrusions are formed evenly. In addition, the texturing on the semiconductor substrate 110 may be, for example, by reactive ion etching (RIE). As such, in the present inventive concept, the semiconductor substrate 110 may be subjected to texturing via various methods.

FIG. 3A illustrates that both the front surface and the back surface of the semiconductor substrate 110 are subjected to texturing so that the reflectance of light introduced through the front surface and the back surface is minimized. However, the embodiment of the present inventive concept is not limited thereto, and various other alterations are possible.

Subsequently, as illustrated in FIGS. 3B to 3F, the conductive areas 20 and 30 are formed on or over the semiconductor substrate 110. In one example, in the present embodiment, the first conductive area 20 is formed by doping the front surface of the semiconductor substrate 110 with a first conductive dopant, and the second conductive area 30 is formed by doping the back surface of the semiconductor substrate 110 with a second conductive dopant. The process of forming the first and second conductive areas 20 and 30 will be described in more detail.

As illustrated in FIG. 3B, the second conductive area 30 is formed on the back surface of the semiconductor substrate 110. Any one known method may be used as the doping process of forming the second conductive area 30. In one example, various methods, such as ion implantation, thermal diffusion using heat treatment in the state in which gas including a dopant is used, heat treatment performed after a doped layer is formed, and laser doping, may be applied. Among these methods, the second conductive area 30 may be formed in a simplified manner only over the back surface of the semiconductor substrate 110 via ion implantation. At this time, the second conductive area 30 for forming a back surface field area, which does not require a relatively high purity, may be formed by an ion implanter not using a mass analyzer. Thereby, equipment cost and manufacturing time may be reduced, which may result in improved productivity. However, the embodiment of the present inventive concept is not limited thereto.

As illustrated in FIG. 3C, the barrier film 12 is formed on the front surface and the back surface of the semiconductor substrate 110. The barrier film 12 may allow a desired dopant or ions to pass or diffuse in the following doping process of forming the first conductive area 20, and may prevent the passage or diffusion of other elements. To this end, the barrier film 12 may be formed of a specific material and may have a specific thickness or a specific index of refraction.

In the present invention, the barrier film 12 is formed of or includes a silicon oxide layer including a silicon oxide, a silicon nitride layer including a silicon nitride, or a silicon carbide layer including a silicon carbide. The silicon oxide layer, the silicon nitride layer, or the silicon carbide layer may be formed at a low temperature on the semiconductor substrate 110 including silicon, and may be easily removed. In particular, the barrier film 12 may be formed of a silicon oxide layer.

When the barrier film 12 includes a silicon oxide layer, the index of refraction of the barrier film 12 may be within a range from 1.4 to 1.6. When the barrier film 12 includes a silicon nitride layer, the index of refraction of the barrier film 12 may be within a range from 1.9 to 2.3. When the barrier film 12 includes a silicon carbide layer, the index of refraction of the barrier film 12 may be within a range from 2.0 to 2.6. The barrier film 12 having this range of index of refraction may have a stabilized structure, thus effectively exerting barrier effects. However, the embodiment of the present inventive concept is not limited thereto, and the index of refraction of the barrier film 12 may change according to, for example, the material and composition of the barrier film 12.

In the instance where the barrier film 12 includes the above-described material, thickness and/or index of refraction, when boron is used as a dopant, B¹¹ ions, which are directly involved in doping, may diffuse or pass through the barrier film 12. However, the barrier film 12 may prevent or restrict the diffusion or passage of a boron compound (e.g. a boron fluoride, BF⁺ or BF²⁺), SiFₓ, and other metal impurities (e.g. Mg, Al, Fe, and Cr), which are heavier and larger than B¹¹ ions. This is because B¹¹ ions are small and light and thus may easily pass through the barrier film 12, whereas BF⁺, BF²⁺, SiFₓ, and metal impurities (e.g. Mg, Al, Fe, and Cr) are large and heavy and thus have difficulty in passing through the barrier film 12.

At this time, the thickness of a first portion 121 of the barrier film 12, which is formed on the front surface of the semiconductor substrate 110, may be equal to or less than the thickness of a second portion 122 of the barrier film 12, which is formed on the back surface of the semiconductor substrate 110. This is because the second portion 122, formed over the second conductive area 30, has a growth rate equal to or greater than that of the first portion 121 formed over the undoped front surface of the semiconductor substrate 110. When the thickness of the second portion 122 is equal to or greater than the thickness of the first portion 121, the second portion 122 may serve as an outward diffusion prevention film for preventing the second conductive dopant, included in the second conductive area 30, from diffusing outward.

In one example, the ratio of the thickness of the first portion 121 to the thickness of the second portion 122 may be within a range from 1:1 to 1:2. When the ratio is below 1:1, the second portion 122 may not sufficiently serve as the outward diffusion prevention film. It may be difficult to form the first portion 121 and the second portion 122 so that the ratio exceeds 1:2. The ratio of the thickness of the first portion 121 to the thickness of the second portion 122 may be within a range from 1:1.05 to 1:1.5 in consideration of, for example, the effects and process conditions of the second portion 122. However, the embodiment of the present inventive concept is not limited thereto. The thickness ratio described above may change according to the doping concentration in the second conductive area 30.

The thickness of the first portion 121 is within a range from 5 nm to 50 nm, and the thickness of the second portion 122 may be within a range from 5 nm to 100 nm. When the thickness of the first portion 121 is below 5 nm, the barrier film 12 may not sufficiently prevent the diffusion of impurities excluding dopant ions. When the thickness of the barrier film 12 exceeds 50 nm, the process time of forming the barrier film 12 may be increased, thus causing deterioration in productivity. When the thickness of the second portion 122 is below 5 nm, the second portion 122 may not sufficiently serve as the outward diffusion prevention film. When the thickness of the barrier film 12 exceeds 100 nm, the process time of forming the barrier film 12 may be increased, thus causing deterioration in productivity. The thickness of the second portion 122 may be within a range from 10 nm to 100 nm so that the second portion 122 effectively serves as the outward diffusion prevention film.

A portion of the barrier film 12, which is located on the side surface of the semiconductor substrate 110, may have the same thickness as the first portion 121 or the second portion 122 (e.g. so that a difference between the thicknesses is within 10%) according to whether the second conductive area 30 is located on the side surface of the semiconductor substrate 110. That is, when the second conductive area 30 is located on the side surface of the semiconductor substrate 110, a portion of the barrier film 12 located on the side surface of the semiconductor substrate 110 may have the same thickness as the second portion 122. When the second conductive area 30 is not located on the side surface of the semiconductor substrate 110, a portion of the barrier film 12 located on the side surface of the semiconductor substrate 110 may have the same thickness as the first portion 121. However, the embodiment of the present inventive concept is not limited thereto.

The barrier film 12 may be formed via various methods. For example, the barrier film 12 may be formed via deposition. In one example, the barrier film 12 may be formed via atmospheric pressure chemical vapor deposition (APCVD). APCVD may allow the barrier film 12 to be easily formed under nonsevere process conditions and may allow the barrier film 12 to be formed on both the front surface and the back surface of the semiconductor substrate 110 via double-sided deposition. More specifically, the barrier film 12 may have no specific pattern or openings, and may be formed throughout the entire surface, i.e. throughout the front surface, the back surface, and the side surface of the semiconductor substrate 110.

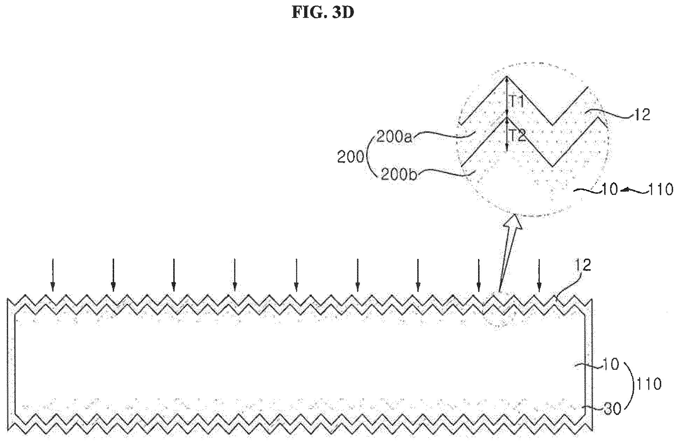

Subsequently, as illustrated in FIG. 3D, a dopant layer 200 is formed on the front surface of the semiconductor substrate 110 via the ion implantation of a first conductive dopant. The introduced first conductive dopant passes through or penetrates a portion in which the barrier film 12 is formed, thereby reaching the front surface of the semiconductor substrate 110. Unlike general ion implantation that is performed using, for example, a mask layer having openings so that a dopant is introduced through the openings, in the present embodiment, the first conductive dopant passes through the barrier film 12 to thereby be introduced into the semiconductor substrate 110. At this time, the first conductive dopant is boron (B). This is because boron ions are small and thus may easily pass through the barrier film 12, whereas other materials are difficult to pass through the barrier film 12.

The dopant layer 200 may include a first dopant layer 200a formed on the barrier film 12, and a second dopant layer 200b formed on the semiconductor substrate 110 adjacent to the barrier film 12. At this time, the thickness T2 of the second dopant layer 200b may be less than the thickness T1 of the first dopant layer 200a. This is because the barrier film 12 prevents the dopant from being deeply doped into the semiconductor substrate 110. In one example, the thickness T2 of the second dopant layer 200b may be within a range from 20% to 40% of the thickness of the dopant layer 200. Because the second dopant layer 200b is relatively thin, the first conductive area 20 formed from the second dopant layer 200b may be thinner than the second conductive area 30.

Conventionally, an ion implanter having a mass analyzer is used to introduce only B¹¹⁻ ions, required for doping, into the first conductive area 20 or the dopant layer 200 for forming the same while removing impurities or unnecessary ions, i.e. a boron compound (e.g. boron fluoride, BF⁺ or BF²⁺), SiFₓ, and metal impurities (e.g. Mg, Al, Fe and Cr). However, the ion implanter having a mass analyzer has expensive equipment cost and increased process time, thus causing low productivity. However, performing ion implantation without a mass analyzer may cause remarkable deterioration in the properties of the first conductive area 20 due to the impurities or unnecessary ions.

In addition, conventionally, an undesired portion (e.g. a portion in which the second conductive area 30 is formed) may be easily doped in a high temperature process, causing counter doping. This may deteriorate the properties of the second conductive area 30.

On the other hand, in the present embodiment, in an ion implantation process, the barrier film 12 filters out materials excluding a dopant (or dopant ions), which may increase the purity of the dopant layer 200 or the first conductive area 20. Thereby, an ion implanter having no mass analyzer is used. That is, in the present embodiment, a low-priced plasma-assisted deposition type ion implanter having no mass analyzer is used, which may reduce the equipment cost and process time, thereby improving productivity. In addition, the second portion 122 of the barrier film 12 may prevent the outward diffusion of the second conductive dopant included in the second conductive area 30, and may prevent the first conductive dopant from being introduced into the second conductive area 30. Thereby, the second conductive area 30 may maintain excellent properties thereof.

In the present embodiment, the dopant in the first conductive area 20, which functions as an emitter area, may be introduced in the state in which impurities are removed using the barrier film 12, whereby the purity and properties of the first conductive area 20, which is directly involved in photoelectric conversion, may be improved. However, the embodiment of the present inventive concept is not limited thereto, and the second conductive area 30 may include boron, and ion implantation may be performed on the second conductive area 30 in the state in which impurities are removed using the barrier film 12. Various other alterations are possible.

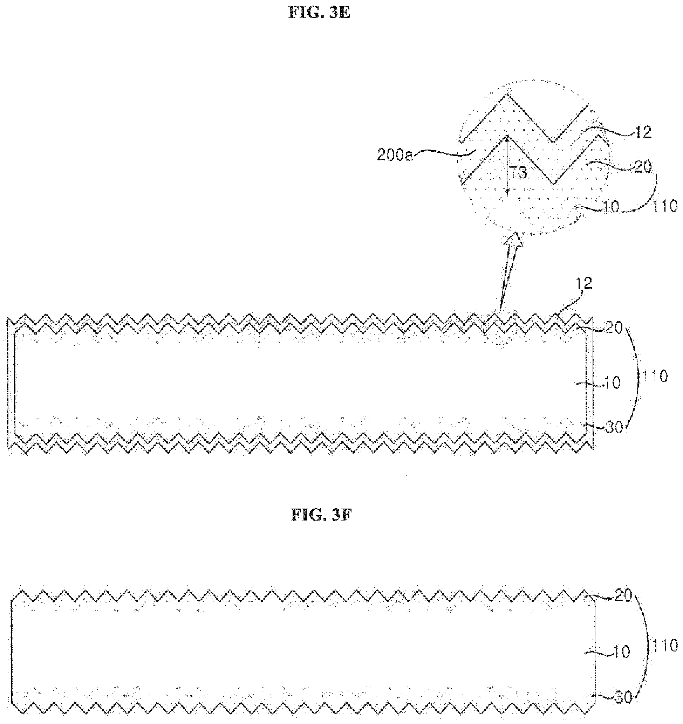

Subsequently, as illustrated in FIG. 3E, the first conductive area 20 is formed via heat treatment by diffusing the first conductive dopant to the front surface of the semiconductor substrate 110 and activating the first conductive dopant.

Because the first conductive area 20 is formed via the diffusion of the first conductive dopant, the thickness T3 of the first conductive area 20 may be greater than the thickness of the barrier film 12 (or the thickness T1 of the first dopant layer 200a) and the thickness T2 of the second dopant layer 200b. For example, the thickness T3 of the first conductive area 20 may be within a range from 10 times to 160 times (e.g. within a range from 10 times to 100 times) the thickness T1 of the first dopant layer 200a. When the ratio is below 10 times, it is difficult to sufficiently form the first conductive area 20. It may be difficult to diffuse the first conductive dopant so that the ratio exceeds 160 times, and the first conductive area 20 may be difficult to form a shallow emitter when the ratio exceeds 160 times. However, the embodiment of the present inventive concept is not limited thereto, and the thicknesses of the first conductive area 200a, the second conductive layer 200b, and the first conductive area 30 may have various values.

Because the dopant layer 200 inside the semiconductor substrate 110 is relatively thin, the first conductive area 20 may also be thinner than the second conductive area 30.

Because the first conductive area 20 is formed via the heat treatment of the dopant layer 200 from which impurities or unnecessary ions have been filtered out as described above, the first conductive area 20 may also have low concentration of impurities, thus achieving high purity and improved properties.

In addition, the second portion 122 of the barrier film 12 may effectively prevent the first conductive dopant in the dopant layer 200, formed on the front surface of the semiconductor substrate 100, from being introduced to the back surface of the semiconductor substrate 110. Thereby, deterioration in the purity or properties of the second conductive area 30 attributable to counter doping may be effectively prevented.

Various known methods may be used as a heat treatment method. In one example, a heat treatment temperature may be within a range from 950 degrees Celsius to 1250 degrees Celsius. Although this temperature range is limited to a temperature at which the introduced first conductive dopant may effectively diffuse, the present inventive concept is not limited thereto. In the present embodiment, when the second conductive area 30 is also formed via ion implantation, the activation of the dopant may be achieved during heat treatment, which may simplify the manufacturing process.

The present embodiment illustrates that activation heat treatment is performed immediately after the dopant layer 200 is formed in the state in which the barrier film 12 is present. However, the embodiment of the present inventive concept is not limited thereto, and heat treatment may be performed after the barrier film 12 is removed. In addition, activation may be performed in another high temperature process, rather than being performed during heat treatment. Various other alterations are possible.

Subsequently, as illustrated in FIG. 3F, the barrier film 12 is removed. The barrier film 12 may be removed various known methods. For example, diluted hydrofluoric acid HF may be used to remove the barrier film 12. A process of using diluted hydrofluoric acid may be performed as a separate process, or the barrier film 12 may be removed using diluted hydrofluoric acid in a washing process.

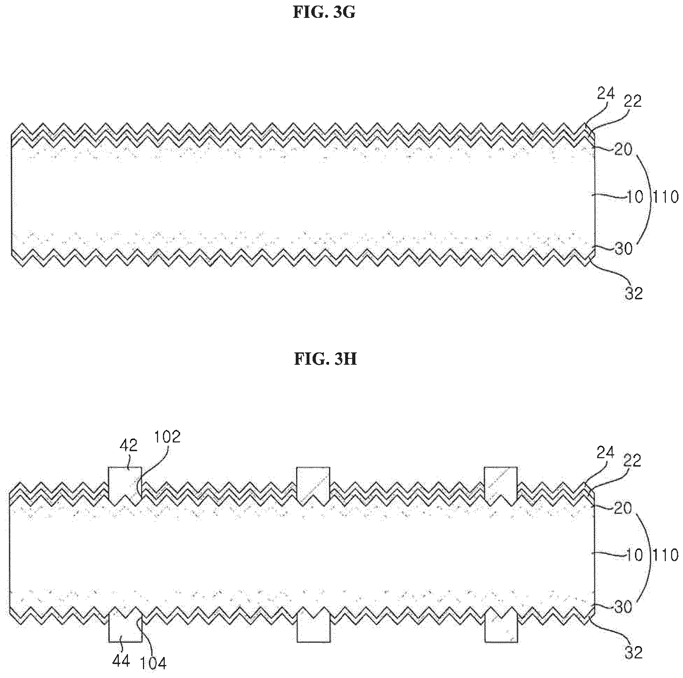

In the present embodiment, subsequently, as illustrated in FIG. 3G, insulation films are formed over the front surface of the semiconductor substrate 110 (or over the first conductive area 20) and/or the back surface of the semiconductor substrate 110 (or over the second conductive area 30).

More specifically, in the present embodiment, the first passivation film 22 and the anti-reflection film 24 are formed over the first conductive area 20, and the second passivation film 32 is formed over the second conductive area 30. However, the embodiment of the present inventive concept is not limited thereto, and only at least one of the first and second passivation films 22 and 32 and the anti-reflection film 24 may be formed.

The first passivation film 22, the anti-reflection film 24 and/or the second passivation film 32 may be formed via various methods, such as vacuum deposition, chemical vapor deposition, spin coating, screen printing, or spray coating.

Subsequently, as illustrated in FIG. 3H, the first and second electrodes 42 and 44 connected respectively to the first and second conductive areas 20 and 30 are formed.

In one example, after the opening 102 is formed in the first passivation film 22 and the anti-reflection film 24 and the opening 104 is formed in the second passivation film 32, the first and second electrodes 42 and 44 may be formed in the openings 102 and 104 by using a conductive material via various methods, such as plating or deposition.

In another example, after paste for the formation of the first and second electrodes 42 and 44 may be applied on the first passivation film 22, the anti-reflection film 24, and/or the second passivation film 32 via screen printing or the like, for example, fire-through phenomenon or laser firing contact may be used in order to form the first and second electrodes 42 and 44 having the above-described shape. In this instance, because the first and second openings 102 and 104 are formed when the first and second electrodes 42 and 44 are formed (in particular, during firing), no process of forming the first and second openings 102 and 104 is added.

In accordance with the present embodiment, ion implantation is performed even without a mass analyzer in the state in which, for example, impurities excluding dopant ions required for ion implantation are removed using the barrier film 12. Because impurities excluding dopant ions may be confined inside the barrier film 12, or only an extremely small amount of impurities may pass through the barrier film 12, the concentration of impurities inside the dopant layer 200 or the first conductive area 20 may be considerably reduced. Thereby, the concentration of impurities in the first conductive area 20 may be reduced, which may result in improved purity and properties. In addition, the equipment cost and the process time may be reduced, which may result in improved productivity.

In addition, because the barrier film 12 serves to reduce the distance over which dopant ions diffuse, the thickness T3 or the junction depth of the first conductive area 20 may be reduced. Thereby, a thin emitter may be formed, which may reduce the saturation current of the solar cell 100, and consequently may increase the open-circuit voltage Voc of the solar cell 100. In addition, the barrier film 12 may prevent the second conductive area 30 from being doped with the first conductive dopant in the process of forming the first conductive area 20, thereby maintaining the excellent properties of the second conductive area 30.

The first and second conductive areas 20 and 30 (more particularly, the first conductive area 20) have been described above as doped areas inside the semiconductor substrate 110 by way of example. However, the embodiment of the present inventive concept is not limited thereto, and at least one of the conductive areas 20 and 30 (in particular, the first conductive area 20) may be configured as a separate amorphous, microcrystalline or polycrystalline semiconductor layer over the semiconductor substrate 110. In this instance, the description of the semiconductor substrate 110 associated with the first conductive area 20 may be applied to the semiconductor layer.

Hereinafter, the present inventive concept will be described in more detail with relation to an experimental example of the present inventive concept. However, the experimental example of the present inventive concept is given by way of example, and the present inventive concept is not limited thereto.

### Experimental Example

The back surface of a semiconductor substrate, having an n-type base area, was doped with phosphorous (P) via ion implantation so as to form a back surface field layer, and a barrier layer, which is a silicon oxide layer, was formed over the front surface and the back surface of the semiconductor substrate. The thickness of the barrier film on the front surface was 20 nm, the thickness of the barrier film on the back surface was 30 nm, and the index of refraction of the barrier film was 1.45. A dopant layer was formed on the front surface of the semiconductor substrate by injecting boron (B) using a plasma-assisted ion implanter having no mass analyzer. Then, heat treatment was performed at 1000 degrees Celsius to activate boron included in the dopant layer while diffusing the same to the front surface of the semiconductor substrate so as to form an emitter layer, and to activate the back surface field layer. Then, the barrier film was removed using diluted hydrofluoric acid. In addition, a front passivation film and an anti-reflection film were formed on the front surface of the semiconductor substrate, and a back passivation film was formed on the back surface of the semiconductor substrate. In addition, a first electrode connected to the emitter layer and a second electrode connected to the back surface field layer were formed. Thereby, a solar cell was manufactured.

### Comparative Example

A solar cell was manufactured by the same method as the experimental example, excluding that boron is introduced into the front surface of the semiconductor substrate using a plasma-assisted ion implanter without forming a barrier film.

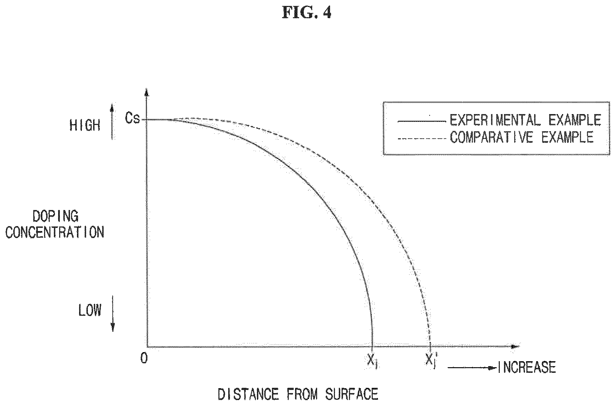

In the solar cells of the experimental example and the comparative example, the concentration of the first conductive dopant depending on the distance from the surface (front surface) of the semiconductor substrate is illustrated in FIG. 4.

Referring to FIG. 4, it can be appreciated that, although the surface doping concentration Cs in the solar cell of the experimental example is similar to the surface doping concentration Cs in the solar cell of the comparative example, the junction depth Xj in the solar cell of the experimental example is smaller than the junction depth Xj' in the solar cell of the comparative example. It is assumed that this is because boron diffuses to the semiconductor substrate after passing through the barrier film, and thus has a relatively small thickness in the experimental example. The reduced junction depth as in the experimental example may reduce saturation current, thus increasing the open-circuit voltage of the solar cell. Thereby, it can be appreciated that the efficiency of the solar cell of the experimental example may be improved.

The above described features, configurations, effects, and the like are included in at least one of the embodiments of the present inventive concept, and should not be limited to only one embodiment. In addition, the features, configurations, effects, and the like as illustrated in each embodiment may be implemented with regard to other embodiments as they are combined with one another or modified by those skilled in the art. Thus, content related to these combinations and modifications should be construed as including in the scope of the inventive concept as disclosed in the accompanying claims.

## Claims

1. A method of manufacturing a solar cell (100) comprising:
forming a barrier film (12) over at least one surface of a semiconductor substrate (110) or a semiconductor layer;
forming a first conductive area (20) on the at least one surface of the semiconductor substrate (110) or the semiconductor layer via ion implantation of a first conductive dopant through the barrier film (12); and
removing the barrier film (12), wherein the first conductive area (20) is formed via ion implantation without using a mass analyzer,
wherein the barrier film (12) includes at least one of a silicon oxide, a silicon nitride,
and a silicon carbide,
wherein the barrier film (12) formed over the at least one surface of the semiconductor substrate (110) or the semiconductor layer has a thickness within a range from 5 nm to 50 nm,
wherein the first conductive dopant includes boron, and
further comprising forming a second conductive area (30) on a remaining surface of the semiconductor substrate (110) or the semiconductor layer, before the forming of the barrier film (12).

2. The method according to claim 1, wherein the barrier film includes a first portion located over the at least one surface, and a second portion located over the remaining surface, and
wherein the second portion has a thickness equal to or greater than a thickness of the first portion.

3. The method according to claim 2, wherein a ratio of the thickness of the first portion to the thickness of the second portion is within a range from 1:1 to 1:2.

4. The method according to any one of claims 1 to 3, wherein the second conductive area is formed via ion implantation without using a mass analyzer.

5. The method according to any one of claims 1 to 4, wherein the first conductive area is subjected to ion implantation using gas, which includes a fluoride including the first conductive dopant, and
wherein the second conductive area is subjected to ion implantation using gas, which includes a hydride including a second conductive dopant.

6. The method according to any one preceding claim, wherein the forming of the first conductive area includes:
forming a dopant layer via ion implantation of the first conductive dopant; and
diffusing and activating the first conductive dopant via heat treatment of the dopant layer.

7. The method according to claim 6, wherein the dopant layer includes a first dopant layer formed on the barrier film, and a second dopant layer formed on a portion of the semiconductor substrate or the semiconductor layer adjacent to the barrier film, and
wherein the second dopant layer has a thickness smaller than a thickness of the first dopant layer.

8. The method according to claim 7, wherein the thickness of the second dopant layer is within a range from 20% to 40% of the thickness of the first dopant layer.

9. The method according to claim 7 or 8, wherein a thickness of the first conductive area is greater than the thickness of each of the first dopant layer and the second dopant layer.

## Patentansprüche

1. Verfahren zum Herstellen einer Solarzelle (100) umfassend:
Bilden eines Barrierefilms (12) über mindestens einer Oberfläche eines Halbleitersubstrats (110) oder einer Halbleiterschicht;
Bilden eines ersten leitfähigen Bereichs (20) auf der mindestens einen Oberfläche des Halbleitersubstrats (110) oder der Halbleiterschicht durch Ionenimplantierung eines Dotierstoffs eines ersten Leitfähigkeitstyps durch den Barrierefilm (12); und
Entfernen des Barrierefilms (12), wobei der erste leitfähige Bereich (20) durch Ionenimplantierung ohne Verwendung eines Massenanalysators gebildet wird, wobei der Barrierefilm (12) mindestens eines von einem Siliziumoxid, einem Siliziumnitrid und einem Siliziumcarbid enthält,
wobei der über der mindestens einen Oberfläche des Halbleitersubstrats (110) oder der Halbleiterschicht gebildete Barrierefilm (12) eine Dicke innerhalb eines Bereichs von 5 nm bis 50 nm aufweist,
wobei der Dotierstoff des ersten Leitfähigkeitstyps Bor enthält, und des Weiteren umfassend
Bilden eines zweiten leitfähigen Bereichs (30) auf einer verbleibenden Oberfläche des Halbleitersubstrats (110) oder der Halbleiterschicht vor der Bildung des Barrierefilms (12).

2. Verfahren nach Anspruch 1, wobei der Barrierefilm einen ersten Abschnitt enthält, der über der mindestens einen Oberfläche angeordnet ist, und einen zweiten Abschnitt enthält, der über der verbleibenden Oberfläche angeordnet ist, und wobei der zweite Abschnitt eine Dicke aufweist, die gleich oder größer ist als eine Dicke des ersten Abschnitts.

3. Verfahren nach Anspruch 2, wobei ein Verhältnis der Dicke des ersten Abschnitts zu der Dicke des zweiten Abschnitts innerhalb eines Bereichs von 1:1 bis 1:2 liegt.

4. Verfahren nach einem beliebigen der Ansprüche 1 bis 3, wobei der zweite leitfähige Bereich durch Ionenimplantierung ohne Verwendung eines Massenanalysators gebildet wird.

5. Verfahren nach einem beliebigen der Ansprüche 1 bis 4, wobei der erste leitfähige Bereich einer Ionenimplantierung unter Verwendung von Gas unterzogen wird, wobei das Gas ein den Dotierstoff des ersten Leitfähigkeitstyps enthaltendes Fluorid enthält, und wobei die zweite leitfähige Fläche einer Ionenimplantierung unter Verwendung von Gas unterzogen wird, wobei das Gas ein Hydrid enthält, welches einen Dotierstoff des zweiten Leitfähigkeitstyps enthält.

6. Verfahren nach einem beliebigen der vorhergehenden Ansprüche, wobei die Bildung des ersten leitfähigen Bereichs umfasst:
Bildung einer Dotierschicht durch Ionenimplantierung des Dotierstoffs des ersten Leitfähigkeitstyps; und
Diffundieren und Aktivieren des Dotierstoffs des ersten Leitfähigkeitstyps durch Wärmebehandlung der Dotierschicht.

7. Verfahren nach Anspruch 6, wobei die Dotierschicht eine erste Dotierschicht enthält, die auf dem Barrierefilm gebildet wird und eine zweite Dotierschicht enthält, die auf einem Abschnitt des Halbleitersubstrats oder der Halbleiterschicht gebildet wird, der an den Barrierefilm angrenzt, und
wobei die zweite Dotierschicht eine Dicke aufweist, die kleiner ist als eine Dicke der ersten Dotierschicht.

8. Verfahren nach Anspruch 7, wobei die Dicke der zweiten Dotierschicht innerhalb eines Bereichs von 20% bis 40% der Dicke der ersten Dotierschicht liegt.

9. Verfahren nach Anspruch 7 oder 8, wobei eine Dicke der ersten leitfähigen Fläche größer ist als die Dicke von sowohl der ersten Dotierschicht als auch der zweiten Dotierschicht.

## Revendications

1. Procédé de fabrication d'une cellule solaire (100) comprenant :
la formation d'un film barrière (12) sur au moins une surface d'un substrat semi-conducteur (110) ou d'une couche semi-conductrice ;
la formation d'une première zone conductrice (20) sur l'au moins une surface du substrat semi-conducteur (110) ou de la couche semi-conductrice par l'intermédiaire d'une implantation ionique d'un premier dopant conducteur à travers le film barrière (12) ; et
l'élimination du film barrière (12),
dans lequel la première zone conductrice (20) est formée par l'intermédiaire d'une implantation ionique sans utiliser d'analyseur de masse,
dans lequel le film barrière (12) comprend au moins un élément parmi un oxyde de silicium, un nitrure de silicium et un carbure de silicium,
dans lequel le film barrière (12) formé sur l'au moins une surface du substrat semi-conducteur (110) ou de la couche semi-conductrice a une épaisseur comprise dans une plage de 5 nm à 50 nm,
dans lequel le premier dopant conducteur comprend du bore, et comprenant en outre la formation d'une seconde zone conductrice (30) sur une surface restante du substrat semi-conducteur (110) ou de la couche semi-conductrice, avant la formation du film barrière (12).

2. Procédé selon la revendication 1, dans lequel le film barrière comprend une première partie située sur l'au moins une surface, et une seconde partie située sur la surface restante, et
dans lequel la seconde partie a une épaisseur supérieure ou égale à une épaisseur de la première partie.

3. Procédé selon la revendication 2, dans lequel un rapport de l'épaisseur de la première partie à l'épaisseur de la seconde partie est compris dans une plage de 1:1 à 1:2.

4. Procédé selon l'une quelconque des revendications 1 à 3, dans lequel la seconde zone conductrice est formée par l'intermédiaire d'une implantation ionique sans utiliser d'analyseur de masse.

5. Procédé selon l'une quelconque des revendications 1 à 4, dans lequel la première zone conductrice est soumise à une implantation ionique en utilisant un gaz, qui comprend un fluorure comprenant le premier dopant conducteur, et
dans lequel la seconde zone conductrice est soumise à une implantation ionique en utilisant un gaz, qui comprend un hydrure comprenant un second dopant conducteur.

6. Procédé selon l'une quelconque des revendications précédentes, dans lequel la formation de la première zone conductrice comprend :
la formation d'une couche de dopant par l'intermédiaire d'une implantation ionique du premier dopant conducteur ; et
la diffusion et l'activation du premier dopant conducteur par l'intermédiaire d'un traitement thermique de la couche de dopant.

7. Procédé selon la revendication 6, dans lequel la couche de dopant comprend une première couche de dopant formée sur le film barrière, et une seconde couche de dopant formée sur une partie du substrat semi-conducteur ou de la couche semi-conductrice adjacente au film barrière, et
dans lequel la seconde couche de dopant a une épaisseur inférieure à une épaisseur de la première couche de dopant.

8. Procédé selon la revendication 7, dans lequel l'épaisseur de la seconde couche de dopant est comprise dans une plage de 20 % à 40 % de l'épaisseur de la première couche de dopant.

9. Procédé selon la revendication 7 ou 8, dans lequel une épaisseur de la première zone conductrice est supérieure à l'épaisseur de chacune de la première couche de dopant et de la seconde couche de dopant.
